# EUROPÄISCHE PATENTSCHRIFT

(11) **EP 0 556 644 B1**
(45) Veröffentlichungstag und Bekanntmachung des Hinweises auf die Patenterteilung: **06.05.1998**
(21) Anmeldenummer: 93101656.2
(22) Anmeldetag: 03.02.1993
(51) Int. Cl.: H03G 1/00, H03G 1/04

(54) **Integrierte Schaltungsanordnung**
Integrated circuit
Circuit intégré

(30) Priorität: 20.02.1992 DE 4205198
(43) Veröffentlichungstag der Anmeldung: 25.08.1993
(73) Patentinhaber: SIEMENS AKTIENGESELLSCHAFT, 80333 München (DE)
(72) Erfinder: Musiol, Lothar, Dipl.-Ing. (FH), W-8000 München 83 (DE)

(56) Entgegenhaltungen:
- EP-A- 0 514 974
- US-A- 4 806 876

## Beschreibung

Die Erfindung betrifft eine integrierte Schaltungsanordnung gemäß dem Oberbegriff des Patentanspruches 1.

Feldeffekttransistoren (FETs) mit zwei Gate-Elektroden (FET-Tetroden) werden in regelbaren Verstärkerschaltungen (Kaskode-Schaltungen) eingesetzt, wobei die erste Gate-Elektrode G1 als Signaleingang verwendet wird, die zweite Gate-Elektrode G2 dagegen als Gleichspannungs-Steuereingang. Bei einer Schaltungsanordnung mit festen Source- und G1-Potentialen sinkt bei Verstärkungsabregelung nur mit G2 der Drainstrom stark ab und es stellen sich Arbeitspunkte ein, die zu großen Signalverzerrungen führen.

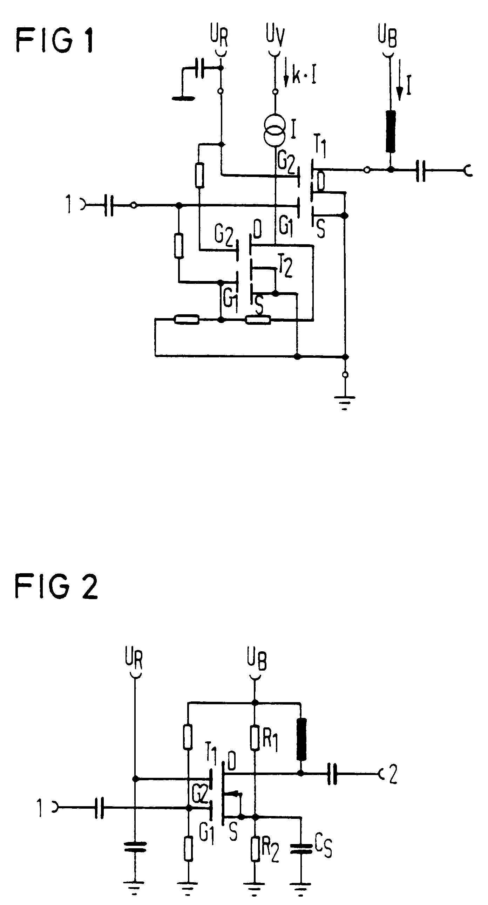

Wie aus FIG 2 ersichtlich, läßt sich dieser Nachteil auf herkömmliche Weise dadurch vermeiden, daß der Source-Anschluß eines zwei Gate-Elektroden G₁ und G₂ aufweisenden Feldeffekttransistors T₁ nur wechselstrommäßig geerdet wird (Cₛ), jedoch stromabhängig im Gleichspannungspotential verschoben wird, und zwar mittels eines Stromteilers mit R₁ und R₂. Bei Abregelung über die zweite Gate-Elektrode G₂ sinkt der Drainstrom und somit der Spannungsabfall über R₂, d. h. das Source-Potential sinkt. Dadurch wird bei Abregelung die Spannungsdifferenz zwischen der ersten Gate-Elektrode G₁ und der Source-Elektrode S so verändert, dass Arbeitspunkte, die zu nichtlinearen Signalverzerrungen führen, weitgehend vermieden werden. Gleichzeitig wird hierbei der Senkung des Drainstromes entgegengewirkt. Mit U_{B} ist die angelegte Betriebsspannung und mit U_{R} die Regelspannung bezeichnet. Der Signaleingang ist mit dem Bezugszeichen 1 und der Signalausgang mit dem Bezugszeichen 2 versehen.

Aus EP 514 974 A1 ist weiterhin eine Schaltungsanordnung bekannt, bei der der Arbeitspunkt eines Feldeffekt-Verstärkertransistors über einen Steuertransistor eingestellt wird.

Der Erfindung liegt die Aufgabe zugrunde, eine integrierte Schaltungsanordnung der eingangs genannten Art zu schaffen, bei der die Arbeitspunkte so eingestellt sind, dass Signalverzerrungen vermieden sind, und zwar ohne externe Bauteile, die als Hilfseinrichtungen dienen, und bei der die Fertigungstoleranzen des signalführenden Feldeffekttransistors weitgehend kompensiert sind.

Diese Aufgabe wird erfindungsgemäß durch eine integrierte Schaltungsanordnung mit den Merkmalen des Anspruches 1 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, daß die Schaltungsanordnung in hinreichend selbstsperrender MOS-Technik realisierbar ist, da hier nicht mit negativen Hilfsspannungen gearbeitet werden soll. Der erste, signalführende Feldeffekttransistor selbst ist in keinem internen Regelkreis enthalten, denn der zweite Feldeffekttransitor als steuerndes Bauelement enthält ("kennt") die elektrischen Eigenschaften des ersten FETs möglichst vollkommen. Der zweite FET bildet somit gegenüber dem ersten, sinalführenden FET ein gleichartiges, wenn auch "verkleinertes" Bauelement. Zudem sind Gate-Elektrode und Source-Elektrode des zweiten (Steuer-) FETs jeweils mit dem gleichen Anschluß des ersten (Signal-) FETs so verbunden, dass gleiche Potentialverhältnisse herrschen. Um nicht die Ähnlichkeit der Kennlinien beider Transistoren einzubüßen, ist es zweckmäßig, dass die Drain-Source-Spannung des Steuertransistors nicht wesentlich niedriger als die des Signaltransistors wird. Da auch bei G2-Abregelung der Drainstrom zunächst nicht stark sinken darf, ist dieser mittels Stromquelle eingeprägt. Der Abfall des Drainstroms bei starker Abregelung stellt sich dabei zwangsläufig ein wegen der endlichen Betriebsspannung, aus der die Stromquelle gespeist wird. Um die Regelschleife des Steuertransistors zu schließen, ist von dessen Drain-Elektrode eine Rückkopplung auf die erste Gate-Elektrode vorgesehen. Der Strom im Rückkoppelzweig ist dabei klein gegenüber dem einzuprägenden Drainstrom.

Anhand der Figuren der Zeichnung wird die Erfindung im folgenden näher erläutert. Es zeigen
- FIG 1: eine Prinzipdarstellung der Schaltungsanordnung,
- FIG 2: eine herkömmliche Schaltungsanordnung und
- FIG 3 bis 6: Ausführungsbeispiele der erfindungsgemäßen Schaltungsanordnung.

Bei der in FIG 1 dargestellten Schaltungsanordnung ist als Steuerschaltungsanordnung erfindungsgemäß ein dem signalführenden bzw. Betriebstransistor T₁ ähnlicher zweiter Transitor T₂ mit ebenfalls mindestens zwei Gate-Elektroden G₁ und G₂ zugeschaltet, dessen Source S, Gate G₁ und Gate G₂ jeweils mit den entsprechenden des ersten Transistors T₁ gleichspannungsmäßig verkoppelt sind. Diesem zweiten bzw. Steuertransistor T₂ wird an der Drain-Elektrode D ein nahezu konstanter Gleichstrom über die Stromquelle I eingeprägt. Die sich einstellende Drainspannung wird auf das Gate G₁ - nach Spannungsteilung oder Spannungssubtraktion - rückgekoppelt, um die erforderliche Gate 1-Spannung einzustellen. Bei Ausführungen mit hoher erforderlicher Gate 1-Spannung ist auch eine direkte Verbindung von Drain D und Gate 1 des Steuertransistors T₂ möglich.

Durch die Ähnlichkeit der beiden Feldeffekttransistoren T₁ und T₂ wird der dem Steuertransistor T₂ eingeprägte Regelverlauf auf den Betriebstransistor T₁ projiziert. Mit sinkender Gate 2-Spannung (Regelspannung U_{R}) steigt also bei beiden Transistoren T₁, T₂ die Gate 1-Spannung an. Ab einer bestimmten Erniedrigung der Gate 2-Spannung kann dem Steuertransistor T₂ der Drainstrom nicht mehr eingeprägt werden, die Gate 1-Spannung steigt aber weiter bis zu einem ausführungsabhängigen Endwert an.

Der zweite bzw. Steuertransistor T₂ kann um einen bestimmten Faktor k = W₂/W₁ kleiner als der erste bzw. Signal- oder Betriebstransistor T₁ ausgelegt werden, wobei, bei nahezu gleicher Gate-Länge der beiden Transistoren, W₁ die Gate-Weite des Signaltranssitors T₁ und W₂ die Gateweite des Steuertransistors T₂ bedeuten. Entsprechend muß dann der eingeprägte Konstantstrom I um den Faktor k kleiner gewählt werden als der am Signaltransistor T₁ erwünschte.

Die sonstigen Eigenschaften wie z.B. Kanallänge und Dotierung sind bei beiden Feldeffekttransistoren T₁ und T₂ zweckmäßig übereinstimmend zu wählen, weil dann der zweite bzw. Steuertransistor T₂ automatisch auf den ersten bzw. signalführenden Transistor T₁ abgeglichen ist.

Trotzdem sind prinzipiell auch Varianten denkbar, bei denen das Regelverhalten des Steuertransistors T₂ in abweichender Form vom Signaltransistor T₁ wiedergegeben wird. Neben Unterschieden in Kanallänge und Dotierung könnte es sich hierbei um Spannungsteiler zwischen Steuer- und Signaltransistor handeln.

Der dem zweiten bzw. Steuertransistor T₂ eingeprägte Strom I kann z.B. aus einer zusätzlichen selbstleitenden FET-Triode in Drainschaltung stammen oder über einen Widerstand einer Spannungsquelle entnommen werden, deren Spannung hinreichend größer ist als die erforderliche Drain-Source-Spannung des Steuertransistors T₂. Durch die Größe und Konstanz bzw. Reproduzierbarkeit dieser Stromquelle I wird das Verhalten der gesamten Schaltungsanordnung mitbestimmt. Einen weiteren Anteil hat auch die Ausführung der Rückkopplung zwischen Drain und Gate G₁ des Steuertransistors T₂.

Die Schaltungsanordnung läßt sich beispielsweise sehr einfach mit selbstsperrenden Dual-Gate-FETs realisieren.

Die Schaltungsanordnung ist aber beispielsweise durch Zuführung eines Stromes über einen Widerstand aus einer negativen Hilfsspannungsquelle in den Gate 1-Teiler auch mit selbstieitenden FETs funktionsfähig.

Eine erfindungsgemäße Schaltungsanordnung ist somit auf Feldeffekttransistoren mit mindestens zwei Gate-Elektroden in MIS- (z.B. Si-MOS) oder MES- (z.B. GaAs-Sperrschicht) Technologie anwendbar.

Eine bevorzugte Anwendung der Schaltungsanordnung ist die monolithische Integration von Steuer(T₂)- und Signaltransistor (T₁) im selben Herstellungsprozeß. Auch eine Konstantstromquelle ist mitintegrierbar.

Die Ankopplung der Gate-Elektroden des zweiten bzw. Steuertransistors T₂ an die des signalführenden ersten Transistors T₁ kann hochohmig erfolgen, insbesondere um das an Gate 1 des Betriebstransistors T₁ eingespeiste Eingangssignal nicht zu bedämpfen. Als Varianten der Schaltungsanordnung sind bei Integration unter Umständen auch die Versorgung der Stromquelle aus der Regelspannung oder der Drainspannung des Signaltransistors T₁ denkbar (Einsparung eines Anschlußbeins).

Außerdem lassen sich bei Integration mehrerer Signaltransistoren T₁ auf dem gleichen Chip vorzugsweise diese gemeinsam mit einem einzigen Steuertransistor T₂ betreiben.

Der Signaleingang ist in den Figuren 1 bis 6 mit dem Bezugszeichen 1 und der Signalausgang mit dem Bezugszeichen 2 versehen. U_{R} bedeutet jeweils die Regelspannung, U_{V} die Versorgungsspannung und U_{B} die Betriebsspannung.

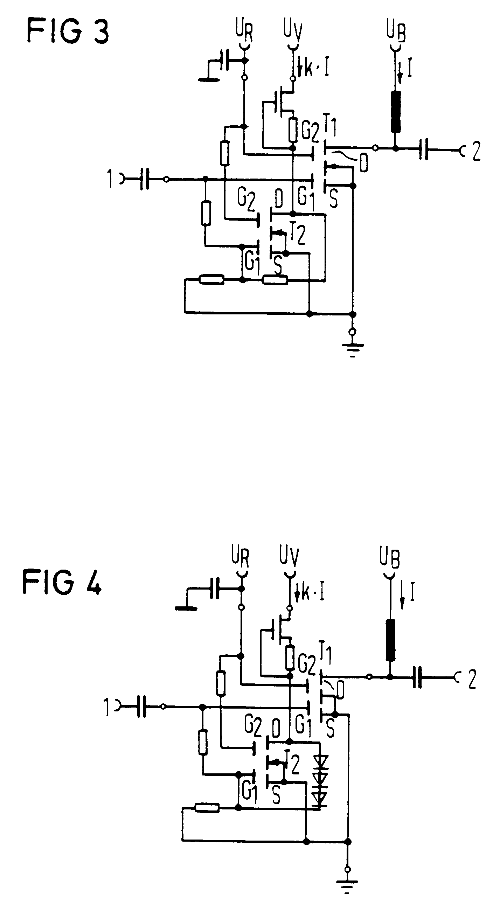

FIG 3 zeigt als Ausführungsbeispiel die Realisierung der erfindungsgemäßen Schaltungsanordnung in MOS-Technologie und ohmschen Spannungsteiler zwischen Drain-Elektrode D und erster Gate-Elektrode G₁ des zweiten Feldeffekt- bzw. Steuertransistors T₂.

FIG 4 zeigt eine weitere Realisierungsmöglichkeit der Schaltungsanordnung in MOS-Technologie, und zwar mit Spannungssubtraktion (Diodenflußspannungen) zwischen erster Gate-Elektrode G₁ und Drain-Elektrode D des Steuertransistors bzw. zweiten Feldeffekttransistors T₂.

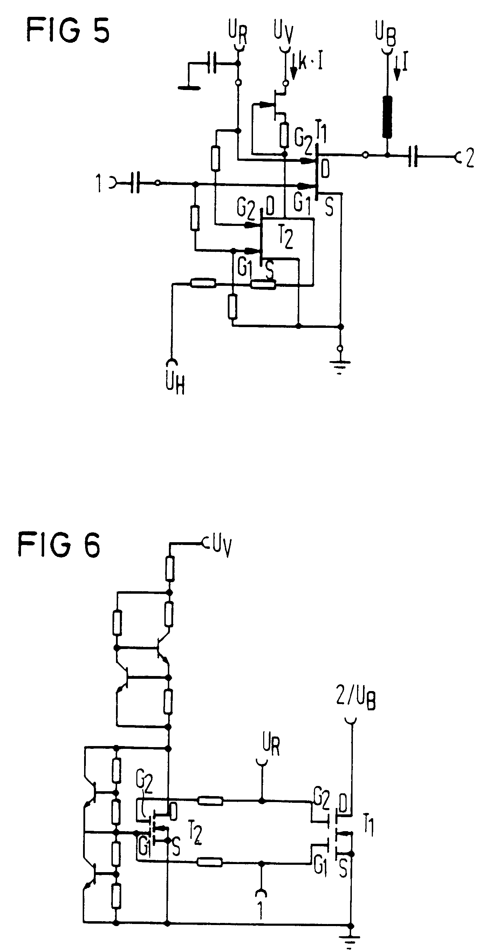

FIG 5 zeigt ein Realisierungsbeispiel der erfindungsgemäßen Schaltungsanordnung in MES-Technologie und negativer Hilfsspannung U_{H} bei selbstleitender Eigenschaft der beiden Transistoren T₁ und T₂.

In der in FIG 6 ohne externe Beschaltung dargestellten Schaltungsanordnung ist die Stromquelle mit einem Bipolartransistor realisiert. Außerdem erfolgt hier die Rückkopplung unter Verwendung nichtlinearer Widerstände, und zwar mittels weiterer bipolarer Transistoren.

Die Erfindung betrifft eine integrierte Schaltungsanordnung zur Spannungssteuerung der Verstärkung eines Feldeffekttransistors mit mindestens zwei Gate-Elektroden, bei dem die erste Gate-Elektrode den Signaleingang und die zweite Gate-Elektrode den Gleichspannungs-Steuereingang bilden.

Feldeffekttransistoren (FETs) mit zwei Gate-Elektroden (FET-Tetroden) werden in regelbaren Verstärkerschaltungen (Kaskode-Schaltungen) eingesetzt, wobei die erste Gate-Elektrode G1 als Signaleingang verwendet wird, die zweite Gate-Elektrode G2 dagegen als Gleichspannungs-Steuereingang. Bei einer Schaltungsanordnung mit festen Source- und G1-Potentialen sinkt bei Verstärkungsabregelung nur mit G2 der Drainstrom stark ab und es stellen sich Arbeitspunkte ein, die zu großen Signalverzerrungen führen.

Die US-A-4 806 876 beschreibt eine FET Verstärkerschaltung bei der eine Diode in den Signaleingang geschaltet ist, mit dem Ziel die Kreuzmodulation des FET zu verringern.

Wie aus FIG 2 ersichtlich, läßt sich dieser Nachteil auf herkömmliche Weise dadurch vermeiden , daß der Source-Anschluß eines zwei Gate-Elektroden G₁ und G₂ aufweisenden Feldeffekttransistors T₁ nur wechselstrommäßig geerdet wird (C_{S}), jedoch stromabhängig im Gleichspannungspotential verschoben wird, und zwar mittels eines Stromteilers mit R₁ und R₂. Bei Abregelung über die zweite Gate-Elektrode G₂ sinkt der Drainstrom und somit der Spannungsabfall über R₂, d.h. das Source-Potential sinkt. Dadurch wird bei Abregelung die Spannungsdifferenz zwischen der ersten Gate-Elektrode G₁ und der Source-Elektrode S so verändert, daß Arbeitspunkte, die zu nichtlinearen Signalverzerrungen führen, weitgehend vermieden werden. Gleichzeitig wird hierbei der Senkung des Drainstromes entgegengewirkt. Mit U_{B} ist die angelegte Betriebsspannung und mit U_{R} die Regelspannung bezeichnet. Der Signaleingang ist mit dem Bezugszeichen 1 und der Signalausgang mit dem Bezugszeichen 2 versehen.

Der Erfindung liegt die Aufgabe zugrunde, eine integrierte Schaltungsanordnung der eingangs genannten Art zu schaffen, bei der die Arbeitspunkte so eingestellt sind, daß Signalverzerrungen vermieden sind, und zwar ohne externe Bauteile, die als Hilfseinrichtungen dienen, und bei der die Fertigungstoleranzen des signalführenden Feldeffekttransistors weitgehend kompensiert sind.

Diese Aufgabe wird erfindungsgemäß durch eine integrierte Schaltungsanordnung mit den Merkmalen des Anspruchs 1 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, daß die Schaltungsanordnung in hinreichend.selbstsperrender MOS-Technik realisierbar ist, da hier nicht mit negativen Hilfsspannungen gearbeitet werden soll. Der erste, signalführende Feldeffekttransistor selbst ist in keinem internen Regelkreis enthalten, denn der zweite Feldeffekttransistor als steuerndes Bauelement enthält ("kennt") die elektrischen Eigenschaften des ersten FETs möglichst vollkommen. Der zweite FET bildet somit gegenüber dem ersten, signalführenden FET ein gleichartiges, wenn auch "verkleinertes" Bauelement. Zudem sind Gate-Elektrode und Source-Elektrode des zweiten (Steuer-) FETs jeweils mit dem gleichen Anschluß des ersten (Signal-)FETs so verbunden, daß gleiche Potentialverhältnisse herrschen. Um nicht die Ähnlichkeit der Kennlinien beider Transistoren einzubüßen, ist es zweckmäßig, daß die Drain-Source-Spannung des Steuertransistors nicht wesentlich niedriger als die des Signaltransistors wird. Da auch bei G2-Abregelung der Drainstrom zunächst nicht stark sinken darf, ist dieser mittels Stromquelle eingeprägt. Der Abfall des Drainstroms bei starker Abregelung stellt sich dabei zwangsläufig ein wegen der endlichen Betriebsspannung, aus der die Stromquelle gespeist wird. Um die Regelschleife des Steuertransistors zu schließen, ist von dessen Drain-Elektrode eine Rückkopplung auf die erste Gate-Elektrode vorgesehen. Der Strom im Rückkoppelzweig ist dabei klein gegenüber dem einzuprägenden Drainstrom.

Anhand der Figuren der Zeichnung wird die Erfindung im folgenden näher erläutert. Es zeigen
- FIG 1: eine Prinzipdarstellung der Schaltungsanordnung,
- FIG 2: eine herkömmliche Schaltungsanordnung und
- FIG 3 bis 6: Ausführungsbeispiele der erfindungsgemäßen Schaltungsanordnung.

Bei der in FIG 1 dargestellten Schaltungsanordnung ist als Steuerschaltungsanordnung erfindungsgemäß ein dem signalführenden bzw. Betriebstransistor T₁ ähnlicher zweiter Transitor T₂ mit ebenfalls mindestens zwei Gate-Elektroden G₁ und G₂ zugeschaltet, dessen Source S, Gate G₁ und Gate G₂ jeweils mit den entsprechenden des ersten Transistors T₁ gleichspannungsmäßig verkoppelt sind. Diesem zweiten bzw. Steuertransistor T₂ wird an der Drain-Elektrode D ein nahezu konstanter Gleichstrom über die Stromquelle I eingeprägt. Die sich einstellende Drainspannung wird auf das Gate G₁ - nach Spannungsteilung oder Spannungssubtraktion - rückgekoppelt, um die erforderliche Gate 1-Spannung einzustellen. Bei Ausführungen mit hoher erforderlicher Gate 1-Spannung ist auch eine direkte Verbindung von Drain D und Gate 1 des Steuertransistors T₂ möglich.

Durch die Ähnlichkeit der beiden Feldeffekttransistoren T₁ und T₂ wird der dem Steuertransistor T₂ eingeprägte Regelverlauf auf den Betriebstransistor T₁ projiziert. Mit sinkender Gate 2-Spannung (Regelspannung U_{R}) steigt also bei beiden Transistoren T₁, T₂ die Gate 1-Spannung an. Ab einer bestimmten Erniedrigung der Gate 2-Spannung kann dem Steuertransistor T₂ der Drainstrom nicht mehr eingeprägt werden, die Gate 1-Spannung steigt aber weiter bis zu einem ausführungsabhängigen Endwert an.

Der zweite bzw. Steuertransistor T₂ kann um einen bestimmten Faktor k = W₂/W₁ kleiner als der erste bzw. Signal- oder Betriebstransistor T₁ ausgelegt werden, wobei, bei nahezu gleicher Gate-Länge der beiden Transistoren, W₁ die Gate-Weite des Signaltranssitors T₁ und W₂ die Gateweite des Steuertransistors T₂ bedeuten. Entsprechend muß dann der eingeprägte Konstantstrom I um den Faktor k kleiner gewählt werden als der am Signaltransistor T₁ erwünschte.

Die sonstigen Eigenschaften wie z.B. Kanallänge und Dotierung sind bei beiden Feldeffekttransistoren T₁ und T₂ zweckmäßig übereinstimmend zu wählen, weil dann der zweite bzw. Steuertransistor T₂ automatisch auf den ersten bzw. signalführenden Transistor T₁ abgeglichen ist.

Trotzdem sind prinzipiell auch Varianten denkbar, bei denen das Regelverhalten des Steuertransistors T₂ in abweichender Form vom Signaltransistor T₁ wiedergegeben wird. Neben Unterschieden in Kanallänge und Dotierung könnte es sich hierbei um Spannungsteiler zwischen Steuer- und Signaltransistor handeln.

Der dem zweiten bzw. Steuertransistor T₂ eingeprägte Strom I kann z.B. aus einer zusätzlichen selbstleitenden FET-Triode in Drainschaltung stammen oder über einen Widerstand einer Spannungsquelle entnommen werden, deren Spannung hinreichend größer ist als die erforderliche Drain-Source-Spannung des Steuertransistors T₂. Durch die Größe und Konstanz bzw. Reproduzierbarkeit dieser Stromquelle I wird das Verhalten der gesamten Schaltungsanordnung mitbestimmt. Einen weiteren Anteil hat auch die Ausführung der Rückkopplung zwischen Drain und Gate G₁ des Steuertransistors T₂.

Die Schaltungsanordnung läßt sich beispielsweise sehr einfach mit selbstsperrenden Dual-Gate-FETs realisieren.

Die Schaltungsanordnung ist aber beispielsweise durch Zuführung eines Stromes über einen Widerstand aus einer negativen Hilfsspannungsquelle in den Gate 1-Teiler auch mit selbstleitenden FETs funktionsfähig.

Eine erfindungsgemäße Schaltungsanordnung ist somit auf Feldeffekttransistoren mit mindestens zwei Gate-Elektroden in MIS- (z.B. Si-MOS) oder MES- (z.B. GaAs-Sperrschicht) Technologie anwendbar.

Eine bevorzugte Anwendung der Schaltungsanordnung ist die monolithische Integration von Steuer(T₂)- und Signaltransistor (T₁) im selben Herstellungsprozeß. Auch eine Konstantstromquelle ist mitintegrierbar.

Die Ankopplung der Gate-Elektroden des zweiten bzw. Steuertransistors T₂ an die des signalführenden ersten Transistors T₁ kann hochohmig erfolgen, insbesondere um das an Gate 1 des Betriebstransistors T₁ eingespeiste Eingangssignal nicht zu bedämpfen. Als Varianten der Schaltungsanordnung sind bei Integration unter Umständen auch die Versorgung der Stromquelle aus der Regelspannung oder der Drainspannung des Signaltransistors T₁ denkbar (Einsparung eines Anschlußbeins).

Außerdem lassen sich bei Integration mehrerer Signaltransistoren T₁ auf dem gleichen Chip vorzugsweise diese gemeinsam mit einem einzigen Steuertransistor T₂ betreiben.

Der Signaleingang ist in den Figuren 1 bis 6 mit dem Bezugszeichen 1 und der Signalausgang mit dem Bezugszeichen 2 versehen. U_{R} bedeutet jeweils die Regelspannung, U_{V} die Versorgungsspannung und U_{B} die Betriebsspannung.

FIG 3 zeigt als Ausführungsbeispiel die Realisierung der erfindungsgemäßen Schaltungsanordnung in MOS-Technologie und ohmschen Spannungsteiler zwischen Drain-Elektrode D und erster Gate-Elektrode G₁ des zweiten Feldeffekt- bzw. Steuertransistors T₂.

FIG 4 zeigt eine weitere Realisierungsmöglichkeit der Schaltungsanordnung in MOS-Technologie, und zwar mit Spannungssubtraktion (Diodenflußspannungen) zwischen erster Gate-Elektrode G₁ und Drain-Elektrode D des Steuertransistors bzw. zweiten Feldeffekttransistors T₂.

FIG 5 zeigt ein Realisierungsbeispiel der erfindungsgemäßen Schaltungsanordnung in MES-Technologie und negativer Hilfsspannung U_{H} bei selbstleitender Eigenschaft der beiden Transistoren T₁ und T₂.

In der in FIG 6 ohne externe Beschaltung dargestellten Schaltungsanordnung ist die Stromquelle mit einem Bipolartransistor realisiert. Außerdem erfolgt hier die Rückkopplung unter Verwendung nichtlinearer Widerstände, und zwar mittels weiterer bipolarer Transistoren.

## Patentansprüche (Patentansprüche für folgende(n) Vertragsstaat(en): DE, FR)

1. Integrierte Schaltungsanordnung zur Steuerung der Verstärkung eines ersten Feldeffekttransistors (T₁) mit mindestens zwei Gate-Elektroden (G₁, G₂), bei dem die erste Gate-Elektrode (G₁) einen Signaleingang (S) und die zweite Gate-Elektrode (G₂) einen Gleichspannungs-Steuereingang bilden, wobei eine integrierte Steuerschaltungsanordnung mit einem zweiten Feldeffekttransistor (T₂), vorgesehen ist, welche die Spannung an der ersten Gate-Elektrode (G₁) des ersten Feldeffekttransistors (T₁) in Abhängigkeit von einer Steuer-Gleichspannung (U_{R}) an dessen zweiter Gate-Elektrode (G₂) einstellt, **dadurch gekennzeichnet**,
dass in eine Drain-Elektrode (D) des zweiten Feldeffekttransistors (T₂) ein nahezu konstanter Gleichstrom (I) eingespeist wird.

2. Integrierte Schaltungsanordnung nach Anspruch 1, **dadurch gekennzeichnet**, dass der zweite Feldeffekttransistor (T₂) mindestens zwei Gate-Elektroden (G₁ G_{2),} eine Drain-Elektrode (D) und eine Source-Elektrode (S) aufweist und dass dessen erste Gate-Elektrode (G₁) mit der ersten Gate-Elektrode (G₁) des ersten Feldeffekttransistors (T₁) und dessen zweite Gate-Elektrode (G₂) mit der zweiten Gate-Elektrode (G₂) des ersten Feldeffekttransistors (T₁) gekoppelt ist.

3. Schaltungsanordnung nach Anspruch 1 oder 2, **dadurch gekennzeichnet**,
dass die Source-Elektrode (S) des ersten Feldeffekttransistors (T₁) auf Masse liegt.

4. Schaltungsanordnung nach einem der Ansprüche 1 bis 3, **dadurch gekennzeichnet**,
dass der zweite Feldeffekttransistor (T₂) bis auf einen Verringerungsfaktor in der Stromaufnahme das gleiche elektrische Verhalten wie der erste Feldeffekttransistor (T₁) aufweist, derart, dass der dem zweiten Feldeffekttransistor (T₂) eingeprägte Regelverlauf auf den ersten Feldeffekttransistor (T₁) übertragbar ist.

5. Schaltungsanordnung nach einem der Ansprüche 1 bis 4, **dadurch gekennzeichnet**,
dass die sich einstellende Drain-Spannung am zweiten Feldeffekttransistor (T₂) zum Einstellen der erforderlichen Spannung an der ersten Gate-Elektrode (G₁) nach entsprechender Spannungsteilung oder Spannungssubtraktion auf die erste Gate-Elektrode (G₁) des zweiten Feldeffekttransistors (T₂) rückgekoppelt ist.

6. Schaltungsanordnung nach Anspruch 5, **dadurch gekennzeichnet,**
dass die Rückkopplung durch direkte Verbindung oder durch Spannungsteilung mit linearen oder nichtlinearen Widerständen erfolgt.

7. Schaltungsanordnung nach Anspruch 5 oder 6, **dadurch gekennzeichnet**,
dass die erste Gate-Elektrode (G₁) des zweiten Feldeffekttransistors (T₂) über eine direkte Verbindung mit dessen Drain-Elektrode (D) sowie über einen Widerstand mit einem Anschluß für Masse gekoppelt ist.

8. Schaltungsanordnung nach einem der Ansprüche 1 bis 7, **dadurch gekennzeichnet**,
dass der zweite Feldeffekttransistor (T₂) bei gleicher Gate-länge wie der erste Feldeffekttransistor (T₁) im Verhältnis der Gateweiten der beiden Transistoren um einen bestimmten Faktor kleiner als der erste Feldeffekttransistor (T₁) ausgelegt ist, so dass der am zweiten Feldeffekttransistor (T2) eingeprägte Strom entsprechend kleiner ist als der am ersten Feldeffekttransistor (T₁) vorgesehene.

9. Schaltungsanordnung nach einem der Ansprüche 1 bis 8, **dadurch gekennzeichnet**,
dass erster und zweiter Feldeffekttransistor (T₁, T₂) im gleichen Herstellungsprozess monolithisch integriert sind.

10. Schaltungsanordnung nach Anspruch 9,
**dadurch gekennzeichnet**,
dass mehrere auf einem Halbleiterchip integrierte erste Feldeffekttransistoren (T₁) gemeinsam mit einem zweiten Feldeffekttransistor (T₂) der Steuerschaltungsanordnung betrieben sind.

## Patentansprüche (Patentansprüche für folgende(n) Vertragsstaat(en): NL)

1. Integrierte Schaltungsanordnung zur Steuerung der Verstärkung eines ersten Feldeffekttransistors (T₁) mit mindestens zwei Gate-Elektroden (G₁, G₂), bei dem die erste Gate-Elektrode (G₁) den Signaleingang und die zweite Gate-Elektrode (G₂) den Gleichspannungs-Steuereingang bilden,
**gekennzeichnet durch** eine integrierte Steuerschaltungsanordnung (T₂), welche eine Spannung an der ersten Gate-Elektrode (G₁) des ersten Feldeffekttransistors (T₁) in Abhängigkeit von einer Steuer-Gleichspannung (U_{R}) an dessen zweiter Gate-Elektrode (G₂) einstellt, wobei das Source-Potential unverändert bleibt.

2. Schaltungsanordnung nach Anspruch 1,
**dadurch gekennzeichnet**, dass der Source-Anschluß des Feldeffekttransitors (T₁) auf Masse liegt.

3. Schaltungsanordnung nach Anspruch 1 oder 2,
**dadurch gekennzeichnet**,
dass die integrierte Schaltungsanordnung einen zweiten Feldeffekttransistor (T₂) umfasst, der ebenfalls mindestens zwei Gate-Elektroden (G₁, G₂) sowie bis auf einen Verringerungsfaktor in der Stromaufnahme das gleiche elektrische Verhalten wie der erste Feldeffekttransitor (T₁) aufweist, derart, dass der dem zweiten Feldeffekttransistor (T₂) eingeprägte Regelverlauf auf den ersten Feldeffekttransistor (T₁) übertragbar ist.

4. Schaltungsanordnung nach einem der Ansprüche 1 bis 3,
**dadurch gekennzeichnet**,
dass die integrierte Steuerschaltungsanordnung einen zweiten Feldeffekttransistor (T₂) umfasst, der mindestens zwei Gate-Elektroden (G₁, G₂), eine Drain-Elektrode (D) und eine Source-Elektrode (S) aufweist, dessen erste Gate-Elektrode (G₁) mit der ersten Gate-Elektrode (G₁) des ersten Feldeffekttransistors (T₁) gekoppelt ist, dessen zweite Gate-Elektrode (G₂) mit der zweiten Gate-Elektrode (G₂) des ersten Feldeffekttransistors (T₁₎ gekoppelt ist, daß dem zweiten Feldeffekttransistor (T₂) der Steuerschaltungsanordnung an dessen Drain-Elektrode ein nahezu konstanter Gleichstrom eingeprägt ist und daß die sich einstellende Drain-Spannung zum Einstellen der erforderlichen Spannung an der ersten Gate-Elektrode (G₁) nach entsprechender Spannungsteilung oder Spannungssubtraktion auf die erste Gate-Elektrode rückgekoppelt ist.

5. Schaltungsanordnung nach Anspruch 4, **dadurch gekennzeichnet,**
dass die Rückkopplung durch direkte Verbindung oder durch Spannungsteilung mit linearen oder nichtlinearen Widerständen erfolgt.

6. Schaltungsanordnung nach Anspruch 4 oder 5, **dadurch gekennzeichnet**,
dass die erste Gate-Elektrode (G₁) des zweiten Feldeffekttransistors (T₁) mit dessen Drain-Elektrode (D) über eine direkte Verbindung sowie über einen Widerstand mit einem Anschluß für Masse gekoppelt ist.

7. Schaltungsanordnung nach einem der Ansprüche 3 bis 6, **dadurch gekennzeichnet**,
dass der zweite Feldeffekttransistor (T₂) bei gleicher Gatelänge wie der erste Feldeffekttransistor (T₁) im Verhältnis der Gateweiten der beiden Transistoren um einen bestimmten Faktor kleiner als der erste Feldeffekttansistor (T₁) ausgelegt ist, so dass der am zweiten Feldeffekttransistor (T₂) eingeprägte Strom entsprechend kleiner ist als der am ersten Feldeffekttransistor (T₁) vorgesehene.

8. Schaltungsanordnung nach einem der Ansprüche 3 bis 7, **dadurch gekennzeichnet**,
dass erster und zweiter Feldeffekttransistor (T₁, T₂) im gleichen Herstellungsprozeß monolithisch integriert sind.

9. Schaltungsanordnung nach Anspruch 8,
**dadurch gekennzeichnet**,
dass mehrere auf einem Halbleiterchip integrierte erste Feldeffekttransistoren (T₁) gemeinsam mit einem zweiten Feldeffekttransistor (T₂) der Steuerschaltungsanordnung betrieben sind.

## Claims (Claims for the following Contracting State(s): DE, FR)

1. Integrated circuit arrangement for controlling the gain of a first field-effect transistor (T₁) having at least two gate electrodes (G₁, G₂), in which the first gate electrode (G₁) forms a signal input (S) and the second gate electrode (G₂) forms a DC voltage control input,
an integrated control circuit arrangement having a second field-effect transistor (T₂) being provided, which sets the voltage at the first gate electrode (G₁) of the first field-effect transistor (T₁) as a function of a control DC voltage (U_{R}) at the second gate electrode (G₂) of the said transistor, characterized in that a virtually constant direct current (I) is fed into a drain electrode (D) of the second field-effect transistor (T₂).

2. Integrated circuit arrangement according to Claim 1, characterized in that the second field-effect transistor (T₂) has at least two gate electrodes (G₁, G₂), a drain electrode (D) and a source electrode (S), and in that its first gate electrode (G₁) is coupled to the first gate electrode (G₁) of the first field-effect transistor (T₁) and its second gate electrode (G₂) is coupled to the second gate electrode (G₂) of the first field-effect transistor (T₁).

3. Circuit arrangement according to Claim 1 or 2, characterized in that the source electrode (S) of the first field-effect transistor (T₁) is connected to earth.

4. Circuit arrangement according to one of Claims 1 to 3, characterized in that the second field-effect transistor (T₂) has the same electrical behaviour as the first field-effect transistor (T₁), except for a reduction factor in the current consumption, in such a way that the control characteristic which is impressed on the second field-effect transistor (T₂) can be transferred to the first field-effect transistor (T₁).

5. Circuit arrangement according to one of Claims 1 to 4, characterized in that the drain voltage established at the second field-effect transistor (T₂), in order to set the required voltage at the first gate electrode (G₁) is fed back to the first gate electrode (G₁) of the second field-effect transistor (T₂) after corresponding voltage division or voltage subtraction.

6. Circuit arrangement according to Claim 5, characterized in that the feedback is effected by direct connection or by voltage division using linear or nonlinear resistors.

7. Circuit arrangement according to Claim 5 or 6, characterized in that the first gate electrode (G₁) of the second field-effect transistor (T₂) is coupled via a direct connection to the drain electrode (D) of the said transistor and is coupled via a resistor to a terminal for earth.

8. Circuit arrangement according to one of Claims 1 to 7, characterized in that the second field-effect transistor (T₂), while having the same gate length as the first field-effect transistor (T₁), is designed to be smaller than the first field-effect transistor (T₁) by a specific factor in terms of the ratio of the gate widths of the two transistors, with the result that the current impressed on the second field-effect transistor (T₂) is correspondingly smaller than that provided on the first field-effect transistor (T₁).

9. Circuit arrangement according to one of Claims 1 to 8, characterized in that the first and second field-effect transistors (T₁, T₂) are monolithically integrated in the same production process.

10. Circuit arrangement according to Claim 9, characterized in that a plurality of first field-effect transistors (T₁) integrated on a semiconductor chip are operated jointly with a second field-effect transistor (T₂) of the control circuit arrangement.

## Claims (Claims for the following Contracting State(s): NL)

1. Integrated circuit arrangement for controlling the gain of a first field-effect transistor (T₁) having at least two gate electrodes (G₁, G₂), in which the first gate electrode (G₁) forms the signal input and the second gate electrode (G₂) forms the DC voltage control input, charactetized by an integrated control circuit arrangement (T₂), which sets a voltage at the first gate electrode (G₁) of the first field-effect transistor (T₁) as a function of a control DC voltage (U_{R}) at the second gate electrode (G2) of the said transistor, the source potential remaining unchanged.

2. Circuit arrangement according to Claim 1, characterized in that the source terminal of the field-effect transistor (T₁) is connected to earth.

3. Circuit arrangement according to Claim 1 or 2, characterized in that the integrated circuit arrangement comprises a second field-effect transistor (T₂), which likewise has at least two gate electrodes (G₁, G₂) and the same electrical behaviour as the first field-effect transistor (T₁), except for a reduction factor in the current consumption, in such a way that the control characteristic which is impressed on the second field-effect transistor (T₂) can be transferred to the first field-effect transistor (T₁).

4. Circuit arrangement according to one of Claims 1 to 3, characterized in that the integrated circuit arrangement comprises a second field-effect transistor (T₂), which has at least two gate electrodes (G₁, G₂), a drain electrode (D) and a source electrode (S), the first gate electrode (G₁) of which is coupled to the first gate electrode (G₁) of the first field-effect transistor (T₁), and the second gate electrode (G₂) of which is coupled to the second gate electrode (G₂) of the first field-effect transistor (T₁), in that a virtually constant direct current is impressed on the drain electrode of the second field-effect transistor (T₂) of the control circuit arrangement, and in that the drain voltage established, in order to set the required voltage at the first gate electrode (G₁), is fed back to the first gate electrode after corresponding voltage division or voltage subtraction.

5. Circuit arrangement according to Claim 4, characterized in that the feedback is effected by direct connection or by voltage division using linear or nonlinear resistors.

6. Circuit arrangement according to Claim 4 or 5, characterized in that the first gate electrode (G₁) of the second field-effect transistor (T₂) is coupled via a direct connection to the drain electrode (D) of the said transistor and is coupled via a resistor to a terminal for earth.

7. Circuit arrangement according to one of Claims 3 to 6, characterized in that the second field-effect transistor (T₂), while having the same gate length as the first field-effect transistor (T₁), is designed to be smaller than the first field-effect transistor (T₁) by a specific factor in terms of the ratio of the gate widths of the two transistors, with the result that the current impressed on the second field-effect transistor (T₂) is correspondingly smaller than that provided on the first field-effect transistor (T₁).

8. Circuit arrangement according to one of Claims 3 to 7, characterized in that the first and second field-effect transistors (T₁, T₂) are monolithically integrated in the same production process.

9. Circuit arrangement according to Claim 8, characterized in that a plurality of first field-effect transistors (T₁) integrated on a semiconductor chip are operated jointly with a second field-effect transistor (T₂) of the control circuit arrangement.

## Revendications (Revendications pour l'(les) Etat(s) contractant(s) suivant(s): DE, FR)

1. Circuit intégré pour commander le gain d'un premier transistor (T₁) à effet de champ, qui comporte au moins deux électrodes (G₁, G₂) de grille et dans lequel la première électrode (G₁) de grille forme une entrée (S) de signaux et la deuxième électrode (G₂) de grille forme une entrée de commande de tension continue, et il est prévu un circuit de commande intégré, qui comporte un deuxième transistor (T₂) à effet de champ et qui règle la tension à la première électrode (G₁) de grille du premier transistor (T₁) à effet de champ en fonction d'une tension (U_{R}) continue de commande à sa deuxième électrode (G₂) de grille, caractérisé en ce qu'un courant (I) continu pratiquement constant est envoyé à une électrode (D) de drain du deuxième transistor (T₂) à effet de champ.

2. Circuit intégré suivant la revendication 1, caractérisé en ce que le transistor (T₂) à effet de champ comporte au moins deux électrodes (G₁, G₂) de grille, une électrode (D) de drain et une électrode (S) de source et en ce que sa première électrode (G₁) de grille est couplée à la première électrode (G₁) de grille du premier transistor (T₁) à effet de champ et en ce que sa deuxième électrode (G₂) de grille est couplée à la deuxième électrode (G₂) de grille du premier transistor (T₁) à effet de champ.

3. Circuit suivant la revendication 1 ou 2, caractérisé en ce que l'électrode (S) de source du premier transistor (T₁) à effet de champ est à la masse.

4. Circuit suivant l'une des revendications 1 à 3, caractérisé en ce que le deuxième transistor (T₂) à effet de champ a, à un facteur de réduction près dans la consommation de courant, le même comportement électrique que le premier transistor (T₁) à effet de champ, de telle manière que la courbe de la régulation appliquée au deuxième transistor (T₂) à effet de champ peut être transmise au premier transistor (T₁) à effet de champ.

5. Circuit suivant l'une des revendications 1 à 4, caractérisé en ce que la tension de drain qui se règle sur le deuxième transistor (T₂) à effet de champ est, en vue de régler la tension exigée à la première électrode (G₁) de grille, rétrocouplée à la première électrode (G₁) de grille du deuxième transistor (T₂) à effet de champ après division de tension ou soustraction de tension adéquate.

6. Circuit suivant la revendication 5, caractérisé en ce que le rétrocouplage s'effectue par liaison directe ou par division de tension par des résistances linéaires ou non linéaires.

7. Circuit suivant la revendication 5 ou 6, caractérisé en ce que la première électrode (G₁) de grille du deuxième transistor (T₂) à effet de champ est couplée à son électrode (D) de drain par l'intermédiaire d'une liaison directe et couplée à une borne destinée à la masse par l'intermédiaire d'une résistance.

8. Circuit suivant l'une des revendications 1 à 7, caractérisé en ce que le deuxième transistor (T₂) à effet de champ est, pour une même longueur de grille que le premier transistor (T₁) à effet de champ, conçu de manière à être plus petit, d'un facteur déterminé, que le premier transistor (T₁) à effet de champ en ce qui concerne les largeurs de grille des deux transistors, si bien que le courant appliqué au deuxième transistor (T₂) à effet de champ est inférieur en conséquence à celui du premier transistor (T₁) à effet de champ.

9. Circuit suivant l'une des revendications 1 à 8, caractérisé en ce que le premier transistor (T₁) à effet de champ et le deuxième transistor (T₂) à effet de champ sont intégrés de manière monolithique au cours du même processus de fabrication.

10. Circuit suivant la revendication 9, caractérisé en ce que l'on fait fonctionner conjointement avec un deuxième transistor (T₂) à effet de champ du circuit de commande plusieurs premiers transistors (T₁) à effet de champ intégrés sur une même puce à semi-conducteurs.

## Revendications (Revendications pour l'(les) Etat(s) contractant(s) suivant(s): NL)

1. Circuit intégré pour commander le gain d'un premier transistor (T₁) à effet de champ, qui comporte au moins deux électrodes (G₁, G₂) de grille et dans lequel la première électrode (G₁) de grille forme une entrée (S) de signaux et la deuxième électrode (G₂) de grille forme une entrée de commande de tension continue
caractérisé par
un circuit de commande intégré (T₂) qui règle une tension à la première électrode (G₁) de grille du premier transistor (T₁) à effet de champ en fonction d'une tension (U_{R}) continue de commande à sa deuxième électrode (G₂) de grille, le potentiel de source restant inchangé.

2. Circuit intégré suivant la revendication 1,
caractérisé
l'électrode (S) de source du transistor (T₁) à effet de champ est à la masse.

3. Circuit suivant la revendications 1 ou 2,
caractérisé
en ce que le circuit intégré comporte un deuxième transistor (T₂) à effet de champ qui comporte également deux électrodes (G₁, G₂) de grille et qui a, à un facteur de réduction près dans la consommation de courant, le même comportement électrique que le premier transistor (T₁) à effet de champ de telle manière que la courbe de la régulation appliquée au deuxième transistor (T₂) à effet de champ peut être transmise au premier transistor (T₁) à effet de champ.

4. Circuit suivant l'une des revendications 1 à 3,
caractérisé
en ce que le circuit intégré de commande comporte un deuxième transistor (T₂) à effet de champ qui a au moins deux électrodes (G₁, G₂) de grille, une électrode (D) de drain et une électrode (S) de source dont la première électrode (G₂) de grile est couplée à la première électrode (G₁) de grille du premier transistor (T₁) à effet de champ, dont la deuxième électrode (G₂) de grille est couplée à la deuxième électrode (G₂) de grille du premier transistor (T₁) à effet de champ, en ce qu'il est appliqué au deuxième transistor (T₂) à effet de champ du circuit de commande sur son électrode de drain une tension continue sensiblement constante et en ce que la tension de drain qui s'établit pour régler la tension nécessaire sur la première électrode (G₁) de grille est rétrocouplée, après division de tension ou soustraction de tension adéquate, à la première électrode grille.

5. Circuit suivant la revendication 4,
caractérisé
en ce que le rétrocouplage s'effectue par liaison directe ou par division de tension par des résistances linéaires ou non linéaires.

6. Circuit suivant la revendication 4 ou 5,
caractérisé
la première électrode (G₁) de grille du deuxième transistor (T₂) à effet de champ est couplée à son électrode (D) de drain par l'intermédiaire d'une liaison directe et couplée à une borne destinée à la masse par l'intermédiaire d'une résistance.

7. Circuit suivant l'une des revendications 3 à 6,
caractérisé
en ce que le deuxième transistor (T₂) à effet de champ est, pour une même longueur de grille que le premier transistor (T₁) à effet de champ, conçu de manière à être plus petit, d'un facteur déterminé, que le premier transistor (T₁) à effet de champ en ce qui concerne les largeurs de grille des deux transistors, si bien que le courant appliqué au deuxième transistor (T₂) à effet de champ est inférieur en conséquence à celui du premier transistor (T₁) à effet de champ.

8. Circuit suivant l'une des revendications 3 à 7,
caractérisé
en ce que le premier transistor (T₁) à effet de champ et le deuxième transistor (T₂) à effet de champ sont intégrés de manière monolithique au cours du même processus de fabrication.

9. Circuit suivant la revendication 8,
caractérisé
en ce que l'on fait fonctionner conjointement avec un deuxième transistor (T₂) à effet de champ du circuit de commande plusieurs premiers transistors (T₁) à effet de champ intégrés sur une même puce à semi-conducteurs.
